# EUROPEAN PATENT SPECIFICATION

(11) **EP 4 304 312 B1**
(45) Date of publication and mention of the grant of the patent: **22.04.2026**
(21) Application number: 22763013.4
(22) Date of filing: 18.02.2022
(51) Int. Cl.: H05K 13/08

(54) **IMAGING DEVICE AND MOUNTING APPARATUS**
ABBILDUNGSVORRICHTUNG UND MONTAGEVORRICHTUNG
DISPOSITIF D'IMAGERIE ET APPAREIL DE MONTAGE

(30) Priority: 03.03.2021 JP 2021033687
(43) Date of publication of application: 10.01.2024
(73) Proprietor: Panasonic Intellectual Property Management Co., Ltd., Kadoma-shi, Osaka 571-0057 (JP)
(72) Inventor: SHIBATA Satoru, Osaka 571-0057 (JP); SUGINO Shimpei, Osaka 571-0057 (JP); EBIHARA Yuto, Osaka 571-0057 (JP)
(74) Representative: Eisenführ Speiser
(86) International application number: PCT/JP2022/006725
(87) International publication number: WO 2022/185957

(56) References cited:
- WO-A1-2018/146732
- WO-A1-2020/144901
- WO-A1-2020/189108
- JP-A- 2003 307 687
- JP-A- 2014 207 271
- JP-A- 2014 216 621
- US-A1- 2012 250 153
- US-A1- 2018 164 529
- US-A1- 2018 376 123
- US-A1- 2019 387 138
- US-B2- 10 743 447

## Description

### TECHNICAL FIELD

The present disclosure relates to an imaging device and a mounting apparatus.

### BACKGROUND ART

US 2018/0376123 A1 discloses an image capture device including a cover coupled to a mount to surround a stereoscopic-camera unit. The stereoscopic-camera unit includes a circuit board coupled to a frame. A floating board-section of the circuit board accommodates expansion and contraction of the frame.

An image capture device according to US 2019/0387138 A1 includes a cover coupled to a mount to surround a stereoscopic-camera unit. The stereoscopic-camera unit includes a circuit board coupled to a frame having a top brace, a bottom brace, and lens holders. The top brace and bottom brace each are formed a similar material as the circuit board (e.g., a FR4 material), such that the top and bottom braces share a similar coefficient of expansion with the circuit board.

WO2018/146732 A1 discloses a component mounting device including: a head unit including a mounting head that mounts a component on a board; a component supply that supplies the component to the mounting head; an imaging section that is provided in the head unit and is capable of imaging a component supply position of the component supply from a plurality of directions; and a controller that acquires the position in a horizontal direction and the height position in a vertical direction of the component at the component supply position on the basis of images of the component supply position captured by the imaging section from the plurality of directions.

### SUMMARY OF THE INVENTION

The present disclosure has been devised in view of the above-described conventional circumstances, and an object thereof is to provide an imaging device and a mounting apparatus capable of further improving position measurement accuracy of an object.

A stereo imaging device according to the present invention is defined in claim 1.

Furthermore, a mounting apparatus according to the present invention is defined in claim 12 and includes the stereo imaging device, a mounting head that is the moving body and mounts a component on a board, a head moving mechanism that moves the mounting head, and a flexible board having one end connected to the sensor board and another end connected to the mounting head. The stereo imaging device captures images of the component retained by the mounting head and a mounting position of the component on the board.

According to the present disclosure, position measurement accuracy of a target can be further improved.

### BRIEF DESCRIPTION OF THE DRAWINGS

Fig. 1 is a perspective view of a main part of a component mounting device including an imaging device according to a first exemplary embodiment.
Fig. 2 is an enlarged view of a main part of the mounting head illustrated in Fig. 1.
Fig. 3 is a perspective view of the mounting head illustrated in Fig. 2 as viewed from a different direction.
Fig. 4 is a side view of the mounting head illustrated in Fig. 3.
Fig. 5 is a perspective view of the imaging device illustrated in Fig. 4.
Fig. 6 is a cross-sectional view taken along line A-A of Fig. 5.
Fig. 7 is an exploded perspective view of the imaging device illustrated in Fig. 5.
Fig. 8 is a front view of the imaging device illustrated in Fig. 5.
Fig. 9 is a perspective view of a holder illustrated in Fig. 7 as viewed from a sensor fixed part side.
Fig. 10 is an enlarged view of a main part of Fig. 6.

### DESCRIPTION OF EMBODIMENTS

### (Background to the present disclosure)

In the component mounting device, in order to improve the accuracy of the mounting position of the component mounted on the board, images of the mounting position of the component and the nozzle tip are captured by the imaging section, and the mounting position of the component is measured by three-dimensional (3D) measurement based on each of the plurality of captured images. In the component mounting device in PTL 1 (component mounting device), the imaging section includes each of a plurality of cameras (for example, stereo cameras), and the images of the mounting position of the component are captured from a plurality of different imaging directions by each of the plurality of cameras. The component mounting device acquires a vertical height position of a component based on each of a plurality of captured images captured from a plurality of different imaging directions, and acquires the position in a horizontal direction and the height position in a vertical direction at a mounting position of component by correcting the horizontal position of the component based on the vertical height position of the component. However, since each of the plurality of cameras performs imaging in a state of being installed in a mounting head that drives at a high speed, there is a possibility that the distance of each of the plurality of cameras varies due to vibration at the time of driving the mounting head. As a result, in the component mounting device, the measurement accuracy of the position in the horizontal direction and the height position in the vertical direction (that is, 3D measurement) at the mounting position of the component is lowered, and there is a possibility that a defect occurs in the mount board on which the component is mounted.

Hereinafter, an exemplary embodiment that specifically discloses configurations and functions of an imaging device and a mounting apparatus according to the present disclosure will be described in detail with reference to the drawings as appropriate. It is noted that a more detailed description than need may be omitted. For example, a detailed description of a well-known matter and a repeated description of substantially the same configuration may be omitted. This is to avoid the unnecessary redundancy in the following description and to make the descriptions easier to understand for those skilled in the art. Note that the accompanying drawings and the following description are provided for those skilled in the art to fully understand the present disclosure, and are not intended to limit the subject matter described in the scope of claims.

### (First exemplary embodiment)

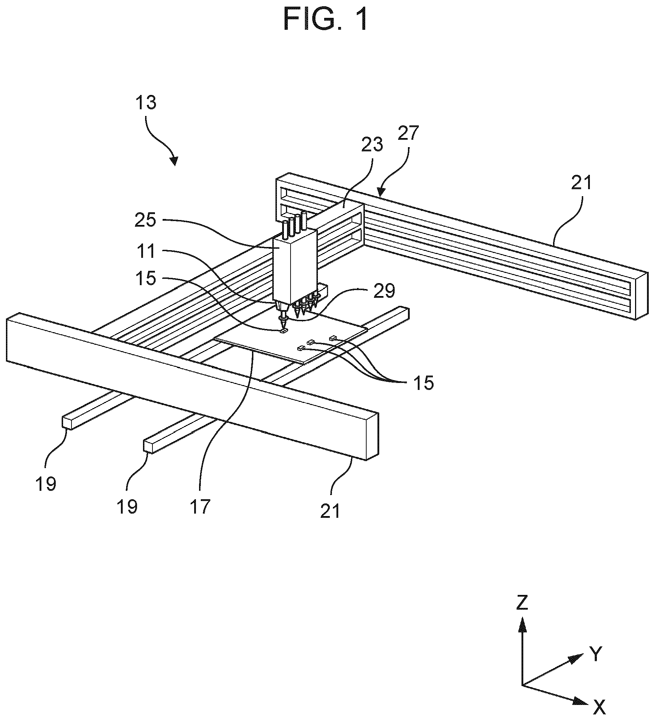

Fig. 1 is a perspective view of a main part of component mounting device 13 including imaging device 11 according to a first exemplary embodiment. In each drawing, XYZ directions follow directions of arrows. In addition, the X-axis indicates the left-right direction, the Y-axis indicates the front-back direction, and the Z-axis indicates the up-down direction.

Component mounting device 13 as an example of a mounting apparatus has a function of mounting component 15 supplied from each of a plurality of component supply devices (not illustrated) at a component mounting position on board 17. The component supply device includes a tape feeder that supplies a carrier tape, which is a tape member in which component 15 is sealed, to a supply position of component 15, a tray feeder that supplies a pallet retaining component 15 to the supply position of component 15, or the like. Examples of component 15 include electronic components such as an integrated circuit (IC), a transistor, a capacitor, and a resistor. The size of component 15 is, for example, 400 µm × 200 µm.

Component mounting device 13 includes a stand (not illustrated). At the center of the stand, each of a pair of board transport conveyors 19 is disposed parallel to each other in the direction along the Y direction. Board transport conveyor 19 transports board 17 unloaded from the device installed on the upstream side of component mounting device 13 in the Y direction and positions the board 17 at a predetermined component mounting position. Each of the pair of board transport conveyors 19 includes a retaining mechanism (not illustrated) that retains board 17 being transported in a state of being stopped at the mounting position. In addition, each of the pair of board transport conveyors 19 is configured to be capable of adjusting the interval in the X direction in accordance with the dimension of board 17.

The component supplies are disposed on both sides of board transport conveyor 19. A cart (not illustrated) capable of collectively mounting each of the plurality of tape feeders to the component mounting machine is set in the component supply.

A pair of parallel X-axis moving rails 21 is disposed along the X direction on the upper surface of the stand. Y-axis moving beam 23 is mounted between the pair of X-axis moving rails 21 so as to be movable in parallel in the X direction. In Y-axis moving beam 23, mounting head 25 as an example of a moving body is mounted so as to be movable in the Y direction. X-axis moving rail 21 and Y-axis moving beam 23 constitute head moving mechanism 27 that moves mounting head 25.

Mounting head 25 moves in the X direction and the Y direction by driving head moving mechanism 27. Thus, mounting head 25 sucks and takes out component 15 supplied from the tape feeder of the component supply by nozzle 29 provided at the lower end of mounting head 25, and mounts the component 15 at a predetermined component mounting position on board 17 positioned on board transport conveyor 19.

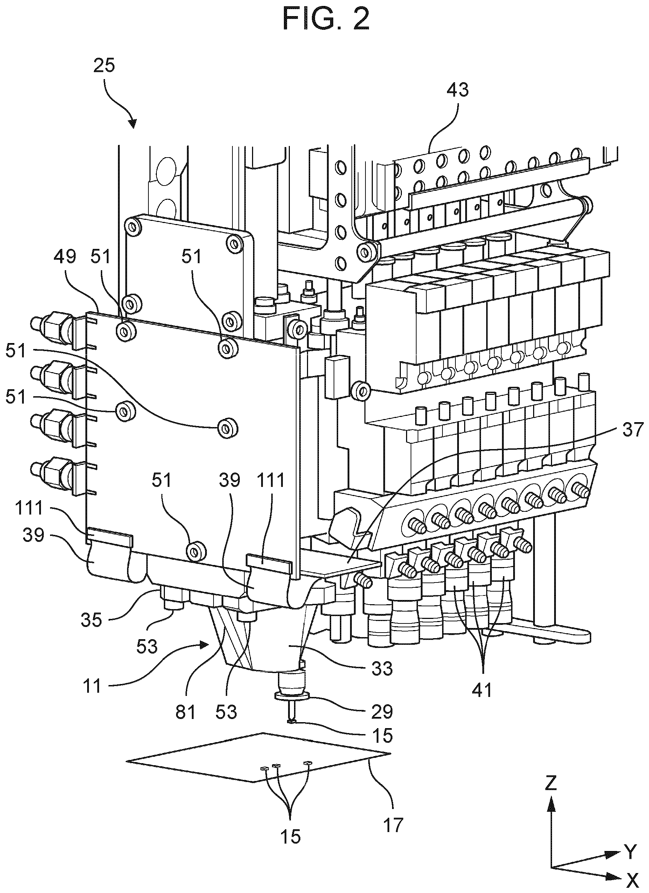

Fig. 2 is an enlarged view of a main part of mounting head 25 illustrated in Fig. 1.

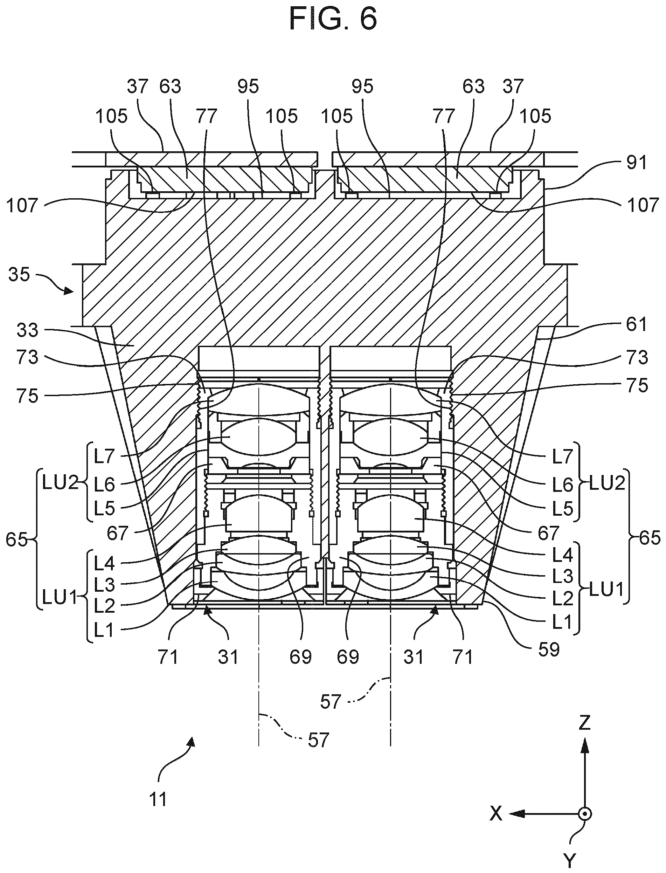

Mounting head 25 includes imaging device 11 that moves integrally to the lower surface side of Y-axis moving beam 23. Imaging device 11 is a so-called stereo camera, and includes each of two cameras. Imaging device 11 is moved above board 17 by mounting head 25, and captures images of component 15 attracted to the tip of nozzle 29 and the upper surface of board 17. Note that the camera in imaging device 11 includes optical system 65 (see Fig. 6) and image sensor 63 (see Fig. 6). Image sensor 63 is, for example, a solid-state imaging element such as a charge-coupled device (CCD) or a complementary metal-oxide-semiconductor (CMOS), converts an optical image formed on an imaging surface into an electric signal, and outputs the converted electric signal to main board 49 via flexible board 39. Main board 49 generates a captured image on the basis of the output electric signal.

Imaging device 11 captures images of the component mounting position of component 15 and the tip of nozzle 29 by each of the two cameras. Component mounting device 13 measures the component mounting position of component 15 by 3D measurement based on the images of the component mounting position of component 15 and the tip of nozzle 29 captured by imaging device 11. Component mounting device 13 calculates a movement amount (for example, distance, angle, and the like) of mounting head 25 to the component mounting position of component 15 based on the measurement result. Component mounting device 13 drives head moving mechanism 27 based on the calculated movement amount to move (convey) component 15 sucked and retained by mounting head 25 to the component mounting position and mounts component 15.

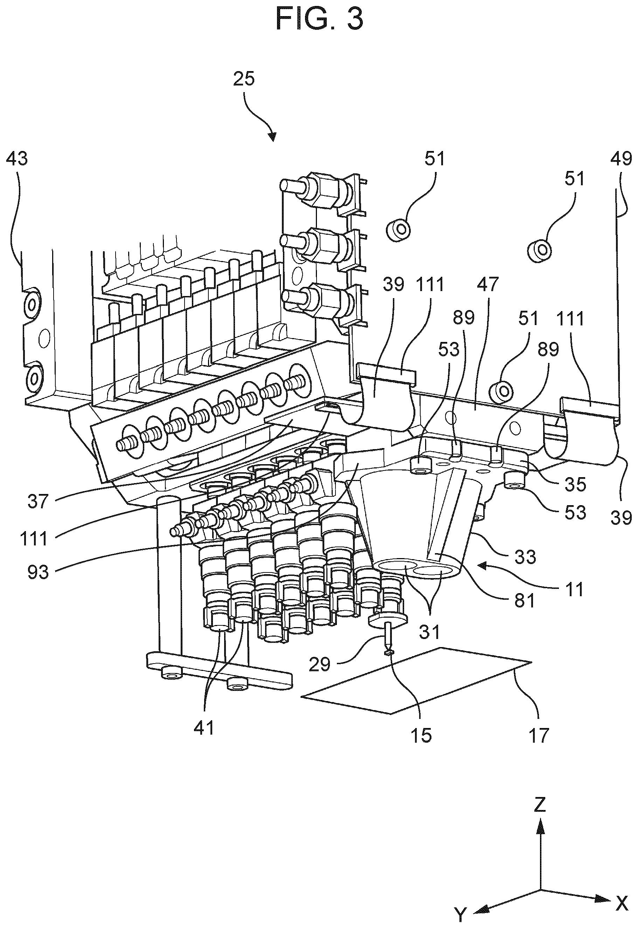

Fig. 3 is a perspective view of mounting head 25 illustrated in Fig. 2 as viewed from different directions.

Imaging device 11 according to the first exemplary embodiment includes two lens barrels 31 (the first lens barrel and the second lens barrel), holder 33, flange portion 35, sensor board 37, and flexible board 39.

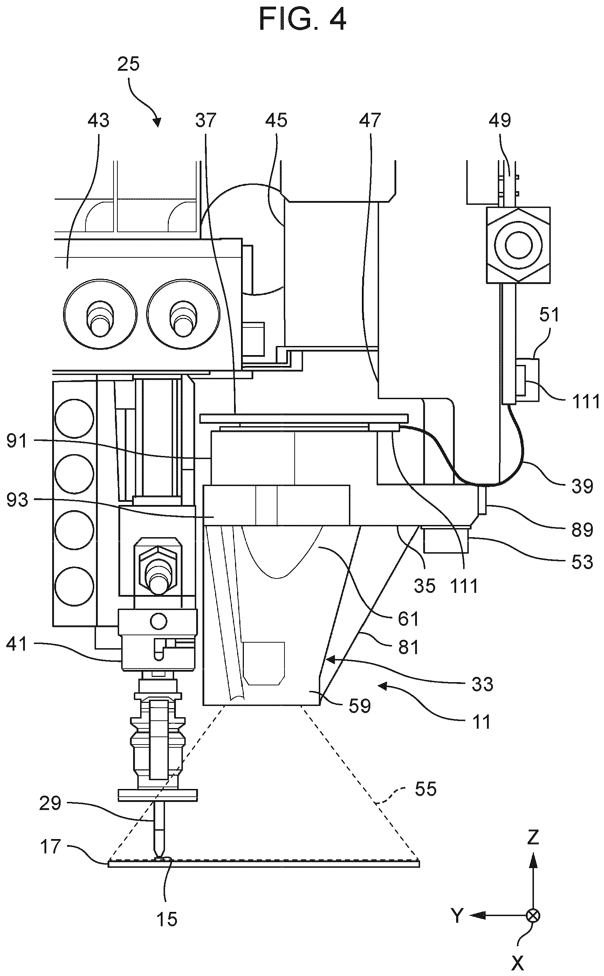

Mounting head 25 includes head main body 43 including one or more nozzle mounting units 41. Camera fixing member 47 is fixed to one end side of head main body 43 in the direction along the Y-axis via connection member 45 (see Fig. 4). Main board 49 for imaging is fixed to a side surface of camera fixing member 47 by a plurality of board fixing bolts 51. In camera fixing member 47, imaging device 11 is fixed between connection member 45 and main board 49 by one or more camera fixing bolts 53.

Fig. 4 is a side view of mounting head 25 illustrated in Fig. 3.

Imaging device 11 is fixedly attached to camera fixing member 47 and attached to mounting head 25, and is disposed close to nozzle mounting unit 41 to which nozzle 29 is attached. As a result, imaging device 11 can be disposed at a position close to nozzle mounting unit 41, that is, at a position where the imaging device 11 can simultaneously capture the images the component mounting position of component 15 on board 17 and component 15 attracted to the tip of nozzle 29.

Since imaging device 11 is disposed close to nozzle mounting unit 41, the component mounting position of component 15 and component 15 sucked to the tip of nozzle 29 can be simultaneously included in respective imaging ranges 55 (that is, the angle of view) of the two cameras. Imaging device 11 can measure the distance to the object (specifically, the component mounting position of component 15 on board 17 and component 15 sucked to the tip of nozzle 29) by 3D measurement (that is, triangulation) by a parallax of each of the two cameras linked with the same specification.

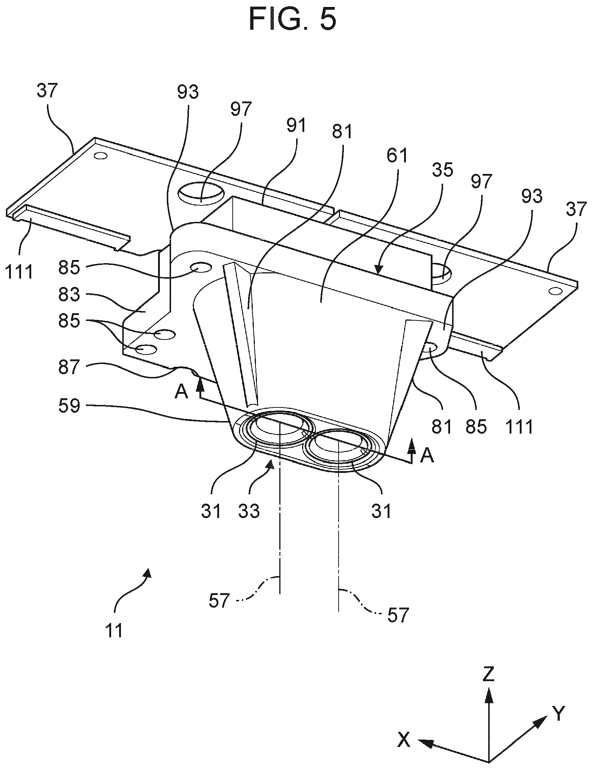

Note that the parallax here means that the appearance of the position, angle, or the like of the object in the imaging space changes as the imaging positions (that is, the observation positions) of the two cameras are shifted. Each of the two cameras is disposed such that optical axes 57 (see Fig. 5) are separated by a predetermined distance and are parallel. Furthermore, under such imaging conditions, each of the image sensors (imaging surfaces) of the two cameras is disposed so as to be on the same plane. As a result, the deviation (difference) of the coordinates of the object appearing in each of the two captured images captured by each of the two cameras becomes a parallax. Note that, since a specific mathematical expression or the like of 3D measurement (triangulation) for calculating the distance to the object on the basis of the parallax is well known, the description thereof will be omitted here.

As a result, component mounting device 13 can improve the measurement accuracy of the component mounting position of component 15 and the position of component 15 at the tip of nozzle 29 by 3D measurement based on the distance from the image sensor (imaging surface) to the object obtained using the parallax by each of the two cameras (stereo cameras).

Fig. 5 is a perspective view of imaging device 11 illustrated in Fig. 4.

Imaging device 11 includes holder 33. Holder 33 covers and fixes each of the plurality of lens barrels 31. Imaging device 11 according to the first exemplary embodiment is, for example, a stereo camera including each of a pair of lens barrels 31. In imaging device 11, the entire length of each of the pair of lens barrels 31 is covered by holder 33 in a direction along optical axis 57 of each optical system 65. Each of the pair of lens barrels 31 is fixed while its entire length is covered by holder 33, whereby a change in the relative position of each of the two cameras is regulated. The object side of holder 33 in the direction along optical axis 57 is tip end 59, and the opposite side is base end 61. That is, lens barrel 31 receives light incident from the object from tip end 59 of holder 33. The light incident on each lens barrel 31 passes through optical system 65 and forms an image on image sensor 63 (see Fig. 6) of sensor board 37 attached to holder 33 on the side opposite to tip end 59. That is, one image sensor 63 (first image sensor) of two image sensors 63 forms an image of light transmitted through one optical system 65, and other image sensor 63 (second image sensor) forms an image of light transmitted through other optical system 65.

Fig. 6 is a cross-sectional view taken along line A-A of Fig. 5.

Lens barrel 31 accommodates optical system 65. Optical axes 57 of optical systems 65 accommodated in the pair of lens barrels 31 are parallel to each other such that light incident from an object is in the same direction. Optical system 65 includes objective side lens unit LU1, eyepiece side lens unit LU2, diaphragm 67, and the like. The objective side lens unit includes first lens L1, second lens L2, third lens L3, and fourth lens L4 from the object side. The eyepiece side lens unit includes fifth lens L5, sixth lens L6, and seventh lens L7 from the object side.

Objective side lens unit LU1 is accommodated in inner cylinder 69, and detachment in the -Z direction is restricted by distal end ring 71. Eyepiece side lens unit LU2 is accommodated in outer cylinder 73, and after diaphragm 67 is inserted from the object side, inner cylinder 69 is coaxially screwed, so that eyepiece side lens unit LU2 is disposed coaxially with objective side lens unit LU1.

Lens barrel 31 includes distal end ring 71, inner cylinder 69, and outer cylinder 73. Lens barrel 31 is fixed to holder 33 by screwing male screw 75 formed on the outer periphery of outer cylinder 73 opposite to distal end ring 71 into female screw 77 of the holder 33. Each of the pair of lens barrels 31 is integrally fixed to holder 33, whereby the relative position of each of the two cameras is retained. As a result, the 3D measurement accuracy of the component mounting position of component 15 based on each of the two captured images captured by imaging device 11 can be improved.

Holder 33 is formed by molding and cutting, for example, an aluminum alloy or the like such that the outer periphery of base end 61 is thicker than the outer periphery of tip end 59. Holder 33 according to the first exemplary embodiment is formed in a substantially truncated pyramid shape such that first lens L1 disposed at tip end 59 formed thinner than base end 61 can take in light incident from an object (see Fig. 5).

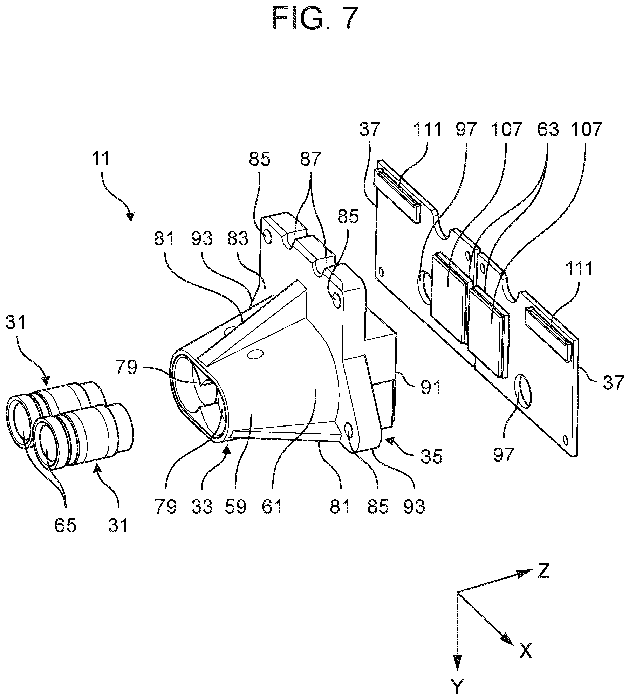

Fig. 7 is an exploded perspective view of imaging device 11 illustrated in Fig. 5.

Holder 33 has an oval shape in which four corners of a substantially rectangular shape are chamfered on the side of base end 61 surface in contact with image sensor 63. In addition, the surface of holder 33 on the side of tip end 59 has a smaller area than the surface on the side of base end 61, and has an oval shape of a similar shape as an example. On the surface of holder 33 on the side of tip end 59, a pair of lens barrel insertion holes 79 into which the pair of lens barrels 31 can be inserted are opened side by side in the direction along the X-axis. On the outer periphery of holder 33, reinforcing rib 81 that has a substantially triangular shape and gradually overhangs from the side of tip end 59 toward the side of base end 61 of holder 33 is formed along the Z-axis. In imaging device 11 of the first exemplary embodiment, as an example, three reinforcing ribs 81 in total are provided on both sides of holder 33 in the direction along the X-axis and one side of holder 33 in the direction along the Y-axis. Needless to say, the shape, position, and number of reinforcing ribs 81 are not limited to these.

Holder 33 has flange portion 35. Flange portion 35 is formed with moving body fixing part 83 protruding from the outer periphery of base end 61 on the opposite side of tip end 59 on which light from the object of holder 33 is incident to both sides of base end 61 along the X-axis and one side (-Y direction side) in the direction along the Y-axis. In flange portion 35, moving body fixing part 83 protruding toward the -Y direction side is fixed to camera fixing member 47, and can move integrally with mounting head 25. Each of a plurality of (for example, two) fixing holes 85 penetrating in the thickness direction is formed in moving body fixing part 83. Further, a pair of positioning depressed portion 87 recessed in a semi-cylindrical shape is formed on an end surface on the -Y direction side of moving body fixing part 83. Each of the pair of positioning depressed portion 87 is engaged with positioning pin 89 hanging down from camera fixing member 47 illustrated in Fig. 3 in the direction along the Z-axis, and is positioned with respect to camera fixing member 47.

As illustrated in Fig. 3, imaging device 11 is positioned and fixed at a predetermined relative position with respect to mounting head 25 by engaging each of the pair of positioning depressed portion 87 of flange portion 35 with the pair of positioning pins 89 and screwing camera fixing bolt 53 inserted through each of the pair of fixing holes 85 with camera fixing member 47. In imaging device 11, by connecting only flange portion 35 to mounting head 25, the stress of imaging device 11 generated by the vibration (external force) at the time of driving (moving) mounting head 25 is absorbed by flange portion 35 formed to protrude from holder 33. As a result, imaging device 11 according to the first exemplary embodiment can absorb the stress on the side of base end 61 where flange portion 35 is formed, and thus, it is possible to reduce stress applied to the side of tip end 59 where optical system 65 is accommodated and to make lens barrel 31 less likely to be deformed. Therefore, imaging device 11 can improve the measurement accuracy of the component mounting position of component 15 and mount component 15 at a more accurate position by further suppressing the change in the relative position of each of the two cameras due to the driving (movement) of mounting head 25.

In addition, above-described reinforcing rib 81 is connected to flange portion 35 formed to protrude from holder 33. A flat, sensor fixed part 91 having a substantially rectangular parallelepiped shape is formed on the surface of flange portion 35 located on the opposite side to the surface (tip end surface) on the side of tip end 59. Sensor fixed part 91 may be formed as a part of holder 33 or may be formed as a part of flange portion 35, and is formed integrally with flange portion 35. That is, an example in which holder 33, reinforcing rib 81, flange portion 35, and sensor fixed part 91 are integrally formed by molding and cutting the same material in imaging device 11 according to the first exemplary embodiment will be described, but the present invention is not limited thereto.

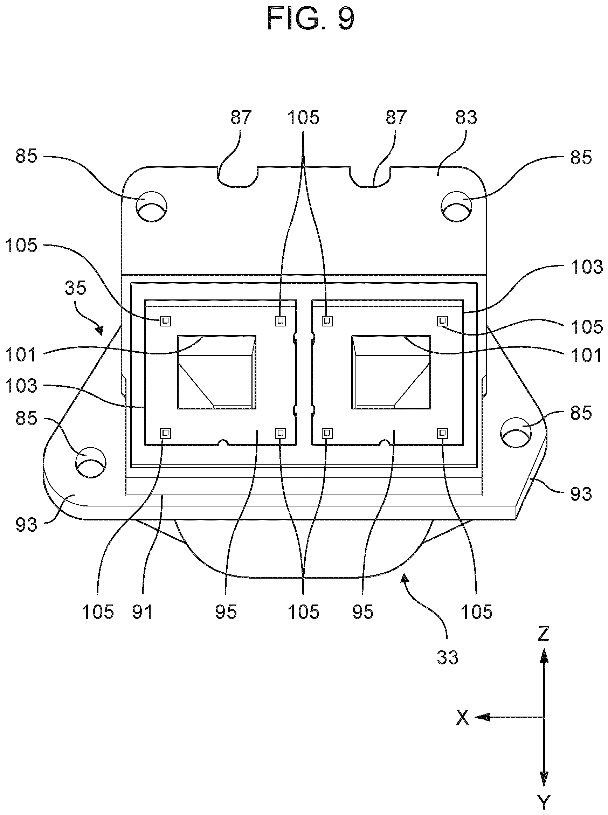

Flange portion 35 is formed with a pair of board fixing parts 93 protruding from both sides of holder 33 along the X-axis and the -X-axis. One or more fixing holes 85 are formed in board fixing part 93. Sensor fixed part 91 formed in holder 33 is attached such that each sensor board 37 on which one image sensor 63 is mounted can receive light transmitted through each optical system 65 by each image sensor 63. In sensor board 37, in a state where image sensor 63 is attached in contact with each of the plurality of protrusions 105 (see Fig. 9) provided on sensor contact surface 95 (see Fig. 6) of sensor fixed part 91, the board fixing bolt inserted into fixing hole 85 of board fixing part 93 protruding from flange portion 35 passes through bolt through-hole 97 and is retained by sensor fixed part 91. That is, base end 61 of holder 33 includes the plurality of protrusions 105, and image sensor 63 is fixed to base end 61 in contact with the plurality of protrusions 105. As a result, image sensor 63 is located on the opposite side of tip end 59 with flange portion 35 interposed therebetween, is positioned according to each lens barrel 31, and is disposed such that light from optical system 65 forms an image.

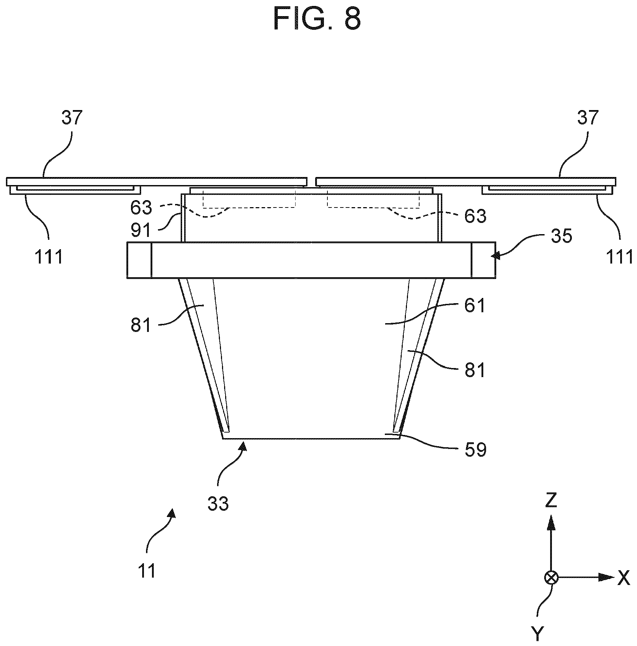

Fig. 8 is a front view of imaging device 11 illustrated in Fig. 5.

In imaging device 11, each of the plurality of protrusions 105 (see Fig. 9) formed on sensor contact surface 95 abuts on image sensor 63, so that the image sensor 63 can be positioned and attached to each optical system 65. Furthermore, in imaging device 11, gap 99 is formed between sensor board 37 and sensor fixed part 91 of holder 33 in a state where image sensor 63 is positioned by each of the plurality of protrusions 105.

As a result, since imaging device 11 includes two sensor boards 37 formed separately for each camera, for example, even in a case where sensor board 37 is warped, image sensor 63 is positioned by each of the plurality of protrusions 105, and the inclination of the light receiving surface of image sensor 63 due to the board warpage can be further suppressed. As illustrated in Fig. 6, two sensor boards 37 (the first sensor board and the second sensor board) are disposed via a gap, and are not directly connected. This makes it difficult to transmit the influence of the board warpage from one sensor board 37 to other sensor board 37. Furthermore, imaging device 11 can absorb the board warpage and inclination of sensor board 37 by gap 99 formed between sensor board 37 and sensor fixed part 91 of holder 33. Therefore, since imaging device 11 can further suppress the positional deviation of image sensors 63 of the two cameras, the position measurement accuracy between the component mounting position of component 15 and the position of component 15 at the tip of nozzle 29 based on the two captured images captured by these cameras can be improved.

Fig. 9 is a perspective view of holder 33 illustrated in Fig. 7 as viewed from the side of sensor fixed part 91.

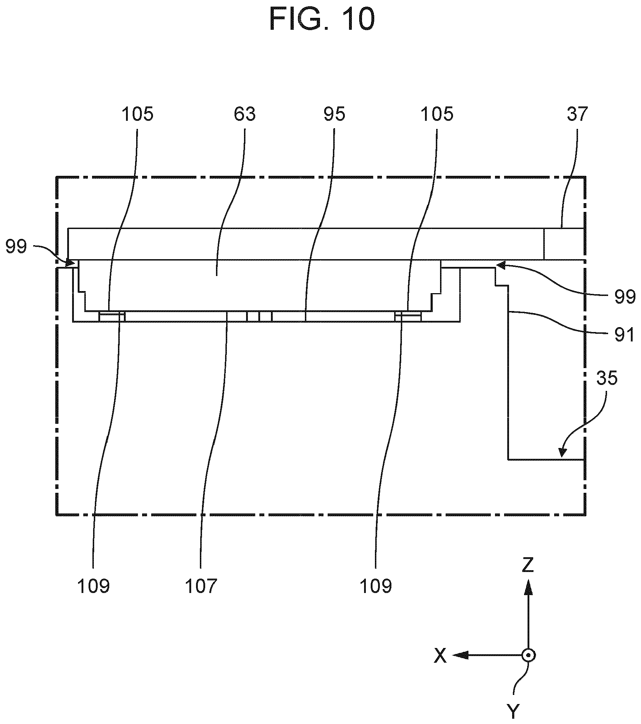

In sensor fixed part 91, a pair of light guiders 101 that allows incident light incident from an object to pass through each lens barrel 31 is provided side by side in a direction along the X-axis. Light guider 101 is formed in, for example, a substantially quadrangular shape. Note that the shape of light guider 101 is an example and is not limited thereto. On the outer periphery of light guider 101, quadrangular frame 103 on which the side surface of image sensor 63 abuts is formed. Each of the plurality of protrusions 105 is provided on sensor contact surface 95 of quadrangular frame 103. A total of four protrusions 105 are provided at four corners of one quadrangular frame 103 at substantially equal intervals. In image sensor 63, non-effective surface 109 (see Fig. 10) which is parallel to light receiving surface 107 (see Fig. 10) and located outside the angle of view of the camera abuts on each of the plurality of protrusions 105, whereby the relative position with respect to optical system 65 is positioned.

As illustrated in Fig. 7, board connector 111 is mounted on each sensor board 37. As illustrated in Fig. 3, one end of flexible board 39 is connected to board connector 111. The other end of flexible board 39 is connected to board connector 111 of main board 49 fixed to camera fixing member 47 of mounting head 25. Main board 49 is a controller configured using a central processing unit (CPU) or a field programmable gate array (FPGA). Main board 49 generates each of the two captured images on the basis of the electrical signal output from each of two image sensors 63. Main board 49 performs image processing by 3D measurement of the component mounting position of component 15 and the position of component 15 at the tip of nozzle 29 based on the object appearing in each of the generated two captured images. Component mounting device 13 calculates the driving (moving) amount (distance, angle, etc.) of mounting head 25 based on the measurement result obtained by measuring the component mounting position of component 15 and the position of component 15 at the tip of nozzle 29, and mounts component 15 at a predetermined component mounting position.

Sensor board 37 is connected to main board 49 via flexible board 39 so as to be able to transmit and receive data. That is, sensor board 37 is not fixedly connected to main board 49 included in mounting head 25. As a result, imaging device 11 can reduce vibration during driving of mounting head 25 transmitted to sensor board 37 and image sensor 63 mounted on sensor board 37.

Note that the connection member connecting sensor board 37 and main board 49 is not limited to flexible board 39, and may be formed of, for example, a material having flexibility and capable of reducing vibration during driving of mounting head 25 to be transmitted to sensor board 37 and image sensor 63 mounted on sensor board 37.

Fig. 10 is an enlarged view of a main part of Fig. 6.

In imaging device 11, light receiving surface 107 of image sensor 63 is positioned at a predetermined angle (typically, substantially vertical) with respect to optical axis 57 of optical system 65 by positioning image sensor 63 by each of the plurality of protrusions 105. In addition, even if sensor board 37 is warped, imaging device 11 can absorb the inclination of board 17 by gap 99. As a result, imaging device 11 can improve the positioning accuracy of image sensor 63 with respect to optical system 65 included in each camera with a simple structure even if sensor board 37 is warped, as compared with a structure in which sensor contact surface 95 and light receiving surface 107 of image sensor 63 are brought into surface contact and positioned.

Note that, in imaging device 11 described above, the configuration including each of two image sensors 63 corresponding to optical system 65 included in each camera and each of two sensor boards 37 has been described, but the number of image sensors 63 and sensor boards 37 is not limited to two. Hereinafter, imaging devices 11 having the different numbers of image sensors 63 and sensor boards 37 will be described.

For example, imaging device 11 may be configured to include one image sensor 63 and one sensor board 37 for optical system 65 included in each camera. In imaging device 11, one image sensor 63 is mounted on one sensor board 37 and receives light transmitted through each optical system 65. Furthermore, holder 33 of such an imaging device 11 may have one sensor contact surface 95, and image sensor 63 may be positionable by at least four protrusions 105 formed on sensor contact surface 95.

For example, imaging device 11 may be configured to include two image sensors 63 and one sensor board 37 with respect to optical system 65 included in each camera. In imaging device 11, two image sensors 63 are mounted on one sensor board 37, and receive light transmitted through each optical system 65.

As described above, imaging device 11 according to the first exemplary embodiment includes: the plurality of lens barrels 31 that are attached to mounting head 25 (an example of the moving body) and house optical system 65 such that light incident from an object (for example, a workpiece such as component 15 or board 17) has the same direction; holder 33 that covers and fixes each of the plurality of lens barrels 31; flange portion 35 that protrudes from the outer periphery of base end 61 on the opposite side of tip end 59 of holder 33 on which light is incident and is fixed to mounting head 25; and sensor board 37 that is mounted with image sensor 63 that forms an image of the light transmitted through optical system 65, is positioned according to the respective positions of the plurality of lens barrels 31 at base end 61 on the opposite side with flange portion 35 interposed therebetween from tip end 59, and is fixed to holder 33.

As a result, in imaging device 11 according to the first exemplary embodiment, each of the plurality of (for example, a pair of) lens barrels 31 is covered by holder 33 and is integrally fixed with holder 33. Holder 33 is formed by, for example, molding and cutting an aluminum alloy or the like. Since each of the pair of lens barrels 31 is integrally fixed to holder 33, optical axis 57 of optical system 65 is less likely to be displaced. For example, when imaging device 11 is attached to mounting head 25 or the like of component mounting device 13, holder 33 operates at a high speed together with mounting head 25. In such a case, an inertial force corresponding to acceleration and mass acts on each of lens barrels 31, but relative positional displacement due to the inertial force is restricted in lens barrel 31 integrally fixed by holder 33, so that displacement is less likely to occur between the optical axes. As a result, it is possible to suppress deterioration of the 3D measurement accuracy due to a change in the distance (position) between each of the pair of lens barrels 31.

In addition, holder 33 has flange portion 35 having a flange shape and protruding from the outer periphery of base end 61. Only flange portion 35 of holder 33 is fixed to the moving body (for example, mounting head 25). In imaging device 11, by connecting only flange portion 35 to the moving body, the stress generated by the high-speed operation of the moving body can be absorbed by flange portion 35. As described above, imaging device 11 has two functions of a function of fixing each of the plurality of lens barrels 31 to holder 33 to suppress the variation in the distance between the plurality of lens barrels 31, and a function of fixing only flange portion 35 to the moving body to absorb the stress by flange portion 35 to suppress the displacement of imaging device 11 with respect to the moving body. Therefore, imaging device 11 can improve the measurement accuracy by having a configuration that exhibits these functions. Note that the moving body is not limited to mounting head 25, and may be, for example, a robot arm or the like.

As described above, holder 33 covers the entire length of each of the plurality of lens barrels 31 in imaging device 11 according to the first exemplary embodiment in the direction along optical axis 57 of optical system 65. As a result, in imaging device 11 according to the first exemplary embodiment, the entire length of each lens barrel 31 is covered and fixed by holder 33. Lens barrel 31 can be formed of a cylinder in which optical axis 57 of optical system 65 coincides with the axis. Therefore, since both ends of lens barrel 31 in the direction along the axis are accommodated and fixed in holder 33, deformation of lens barrel 31 in the direction in which the axis is bent due to the high-speed operation is suppressed. That is, imaging device 11 can suppress bending of optical axis 57 in optical system 65, and can suppress displacement of relative positions of images formed by respective optical systems 65. As a result, imaging device 11 can improve the 3D measurement accuracy.

As described above, holder 33 in imaging device 11 according to the first exemplary embodiment has base end 61 thicker than tip end 59. As a result, holder 33 according to the first exemplary embodiment is formed such that the cross-sectional area orthogonal to the axis (also referred to as optical axis 57) of lens barrel 31 decreases at tip end 59 along the axis and increases at base end 61. As described above, in imaging device 11 according to the first exemplary embodiment, base end 61 in which flange portion 35 is formed is thick in holder 33, and tip end 59 accommodating optical system 65 is formed to be thin, so that the rigidity of base end 61 can be enhanced more than the rigidity of tip end 59. Therefore, holder 33 formed of a homogeneous material is adjusted so that the center of gravity is positioned closer to base end 61 on which flange portion 35 is formed than tip end 59 that accommodates and fixes each optical system 65 therein, and the stress generated when mounting head 25 moves on the side of base end 61 (that is, the flange side) can be concentrated and absorbed on the side of base end 61 side on which flange portion 35 is formed. That is, imaging device 11 can suppress the positional change of each of two optical systems 65 accommodated in tip end 59, and can efficiently suppress the positional deviation of each of the two cameras.

Here, the stress generated by the high-speed operation varies depending on the inertial force acting on imaging device 11, the fulcrum position supporting imaging device 11, the rigidity of imaging device 11, and the gravity center position of imaging device 11. The inertial force can be considered to act on the gravity center of holder 33. In holder 33, flange portion 35 is formed at base end 61 where the gravity center position is located, and flange portion 35 is fixed to the moving body. That is, a fulcrum exists in flange portion 35. Since holder 33 is formed of a homogeneous material, the rigidity of base end 61 having a large cross-sectional area is higher than that of tip end 59 having a small cross-sectional area. Since holder 33 is configured such the gravity center and the fulcrum are close to each other at base end 61 having high rigidity, the stress generated by inertia can be absorbed by being supported by base end 61 having high rigidity.

Therefore, holder 33 can effectively suppress a change in the relative position in the pair of lens barrels 31 as compared with a structure in which the center of gravity is located at tip end 59 covering lens barrel 31 and flange portion 35 of base end 61 away from the center of gravity is supported by the moving body and a structure in which flange portion 35 supported by the moving body is formed at tip end 59 covering lens barrel 31 and the center of gravity is located at base end 61 away from flange portion 35.

As a result, in imaging device 11, the stress generated by the high-speed operation of mounting head 25 concentrates on the connection part between flange portion 35 and base end 61, the deformation of holder 33 is less likely to occur, and the change in the relative position of lens barrel 31 is less likely to occur.

As described above, holder 33 in imaging device 11 according to the first exemplary embodiment has the plurality of protrusions 105 on sensor contact surface 95 (an example of the contact surface) with which image sensor 63 is in contact. With this configuration, image sensor 63 according to the first exemplary embodiment is brought into contact with each of the plurality of protrusions 105, whereby light receiving surface 107 is positioned at a predetermined angle (generally perpendicular) with respect to optical axis 57 of optical system 65. Therefore, it is not necessary to manage the flatness of image sensor 63 with higher accuracy as compared with a structure in which sensor contact surface 95 and light receiving surface 107 of image sensor 63 are brought into contact with each other. As a result, the height of sensor contact surface 95 can be positioned with high accuracy by easy manufacturing, and the relative positional accuracy between optical system 65 and image sensor 63 can be improved.

Furthermore, as described above, sensor board 37 in imaging device 11 according to the first exemplary embodiment is fixed to flange portion 35 with gap 99. In other words, as illustrated in Figs. 8 and 10, sensor board 37 is fixed to base end 61 via gap 99. As a result, imaging device 11 according to the first exemplary embodiment can improve the relative positional accuracy between optical system 65 and image sensor 63 without being affected by distortion (board warpage, unevenness, or the like) of sensor board 37.

Furthermore, as described above, sensor board 37 in imaging device 11 according to the first exemplary embodiment is mounted with one image sensor 63 and fixed according to the position of each of the plurality of lens barrels 31. As a result, in imaging device 11 according to the first exemplary embodiment, since each of the plurality of image sensors 63 is not mounted on one sensor board 37, even in a case where there is distortion (board warpage, unevenness, or the like) in sensor board 37, image sensor 63 can be positioned and fixed corresponding to each position of optical system 65 accommodated in each of the plurality of lens barrels 31. Therefore, imaging device 11 can efficiently suppress the positional deviation of image sensor 63, and can more efficiently improve the relative positional accuracy between each optical system 65 and image sensor 63.

As described above, component mounting device 13 according to the first exemplary embodiment including: board transport conveyor 19 that positions board 17; mounting head 25 that mounts sucked component 15 on board 17; and head moving mechanism 27 that moves mounting head 25; in which the plurality of lens barrels 31 accommodating optical system 65 and in which the light incident from the object is in the same direction; holder 33 that covers and fixes the plurality of lens barrels 31; flange portion 35 that protrudes from the outer periphery of base end 61 on the opposite side of tip end 59 on which the light of holder 33 is incident and is fixed to mounting head 25; sensor board 37 that is mounted with image sensor 63 that forms an image of the light transmitted through optical system 65, is positioned according to the respective positions of lens barrels 31 on the opposite side with flange portion 35 interposed therebetween from tip end 59, and is fixed to flange portion 35; and flexible board 39 connecting to main board 49 having one end connected to sensor board 37 and the other end fixed to mounting head 25.

Further, as described above, component mounting device 13 according to the first exemplary embodiment including: mounting head 25 that mounts component 15 on board 17; head moving mechanism 27 that moves mounting head 25; and imaging device 11 (an example of the imaging section) that images component 15 retained by mounting head 25 and the mounting position of component 15 on board 17. Imaging device 11 including: the plurality of lens barrels 31 in which optical system 65 is accommodated and light incident from an object (for example, a workpiece such as component 15 or board 17) has the same direction; holder 33 that covers and fixes each of the plurality of lens barrels 31; flange portion 35 that protrudes from an outer periphery of base end 61 on a side opposite to tip end 59 of holder 33 on which the light is incident and is fixed to mounting head 25; sensor board 37 on which image sensor 63 that forms an image of the light transmitted through optical system 65 is mounted, being positioned according to respective positions of the plurality of lens barrels 31 at base end 61 on the opposite side across flange portion 35 from tip end 59 and fixed to holder 33; and flexible board 39 having one end connected to sensor board 37 and the other end connected to mounting head 25.

As a result, in imaging device 11 according to the first exemplary embodiment, each of the plurality of (for example, a pair of) lens barrels 31 is covered by holder 33 and is integrally fixed with holder 33. Holder 33 is formed by, for example, molding and cutting an aluminum alloy or the like. Since each of the pair of lens barrels 31 is integrally fixed to holder 33, optical axis 57 of optical system 65 is less likely to be displaced. For example, when imaging device 11 is attached to mounting head 25 or the like of component mounting device 13, holder 33 operates at a high speed together with mounting head 25. In such a case, an inertial force corresponding to acceleration and mass acts on each of lens barrels 31, but relative positional displacement due to the inertial force is restricted in lens barrel 31 integrally fixed by holder 33, so that displacement is less likely to occur between the optical axes. As a result, it is possible to suppress deterioration of the 3D measurement accuracy due to a change in the distance (position) between each of the pair of lens barrels 31.

In addition, holder 33 has flange portion 35 having a flange shape and protruding from the outer periphery of base end 61. Only flange portion 35 of holder 33 is fixed to mounting head 25. In imaging device 11, by connecting only flange portion 35 to mounting head 25, the stress generated by the high-speed operation of mounting head 25 can be absorbed by flange portion 35. As described above, imaging device 11 has two functions of a function of fixing each of the plurality of lens barrels 31 to holder 33 to suppress the variation in the distance between the plurality of lens barrels 31, and a function of fixing only flange portion 35 to mounting head 25 to absorb the stress by flange portion 35 to suppress the displacement of imaging device 11 with respect to mounting head 25. Therefore, imaging device 11 can improve the measurement accuracy by having a configuration that exhibits these functions.

In the first exemplary embodiment, the case where the moving body is the mounting head of the component mounting device has been described as an example, but the moving body may be a robot arm or the like. In this case, the imaging device is attached to an arm distal end (for example, a hand) of a robot. The robot can perform control to cause the hand to retain the workpiece by detecting the distance to the object (workpiece) by the principle of triangulation using the imaging device.

Although various exemplary embodiments have been described above with reference to the accompanying drawings, the present disclosure is not limited to such examples.

### INDUSTRIAL APPLICABILITY

The present disclosure is useful as a presentation of an imaging device and a mounting apparatus capable of further improving the position measurement accuracy of a target.

### REFERENCE MARKS IN THE DRAWINGS

- 11: imaging device
- 13: component mounting device
- 15: component
- 17: board
- 19: board transport conveyor
- 25: mounting head
- 27: head moving mechanism
- 31: lens barrel
- 33: holder
- 35: flange portion
- 37: sensor board
- 39: flexible board
- 49: main board
- 57: optical axis
- 59: tip end
- 61: base end
- 63: image sensor
- 65: optical system
- 91: sensor fixed part
- 95: sensor contact surface
- 99: gap
- 105: protrusion

## Claims

1. A stereo imaging device (11) attached to a moving body (25) and configured to image an object (15, 17), the imaging device (11) comprising:
a first lens barrel (31) that accommodates a first optical system (65);
a second lens barrel (31) that accommodates a second optical system (65), an optical axis (57) of the first optical system (65) being parallel to an optical axis (57) of the second optical system (65);
a holder (33) that covers and fixes the first lens barrel (31) and the second lens barrel (31) and includes a tip end (59) which light from the object (15, 17) enters and a base end (61) on an opposite side of the tip end (59);
a flange portion (35) protruding from an outer periphery of the base end (61) and fixed to the moving body (25);
an image sensor (63) configured to form an image of the light transmitted through the first optical system (65) and the second optical system (65); and
a sensor board (37) on which the image sensor (63) is mounted,
wherein the image sensor (63) is fixed to the base end (61) of the holder (33).

2. The stereo imaging device (11) according to claim 1, wherein an entire length of the first lens barrel (31) in a direction along an optical axis (57) of the first optical system (65) and an entire length of the second lens barrel (31) along an optical axis (57) of the second optical system (65) are covered by the holder (33).

3. The stereo imaging device (11) according to claim 1 or 2, wherein the base end (61) is thicker than the tip end (59).

4. The stereo imaging device (11) according to claim 1, wherein
the base end (61) of the holder (33) has a plurality of protrusions (105), and
the image sensor (63) is fixed to the base end (61) in contact with the plurality of protrusions (105).

5. The stereo imaging device (11) according to claim 4, wherein the sensor board (37) is fixed to the base end (61) via a gap (99).

6. The stereo imaging device (11) according to claim 1, wherein the image sensor (63) includes one image sensor (63).

7. The stereo imaging device (11) according to claim 1, wherein the image sensor (63) includes a first image sensor (63) that forms an image of light transmitted through the first optical system (65) and a second image sensor (63) that forms an image of light transmitted through the second optical system (65).

8. The stereo imaging device (11) according to claim 7, wherein
the base end (61) of the holder (33) includes a plurality of first protrusions (105) and a plurality of second protrusions (105),
the first image sensor (63) is fixed to the base end (61) in contact with the plurality of first protrusions (105), and
the second image sensor (63) is fixed to the base end (61) in contact with the plurality of second protrusions (105).

9. The stereo imaging device (11) according to claim 8, wherein
the sensor board (37) includes a first sensor board (37) on which the first image sensor (63) is mounted and a second sensor board (37) on which the second image sensor (63) is mounted, and
the first sensor board (37) and the second sensor board (37) are disposed via a gap (99).

10. The stereo imaging device (11) according to claim 1, wherein
the first optical system (65) includes a plurality of lenses (L1-L7), and
the second optical system (65) includes a plurality of lenses (L1-L7).

11. The stereo imaging device (11) according to claim 1, wherein the flange portion (35) has a plurality of fixing holes (85) for fixing the flange portion (35) to the moving body (25).

12. A mounting apparatus (13) comprising:
a stereo imaging device (11) according to any one of claims 1 to 11;
a mounting head (25) that is the moving body (25) and mounts a component (15) on a board (17);
a head moving mechanism (27) that moves the mounting head (25); and
a flexible board (39) having one end connected to the sensor board (37) and another end connected to the mounting head (25),
wherein the stereo imaging device (11) captures images of the component (15) retained by the mounting head (25) and a mounting position of the component (15) on the board (17).

## Patentansprüche

1. Stereo-Bildaufnahmevorrichtung (11), die an einem beweglichen Körper (25) angebracht ist und ausgestaltet ist, ein Objekt (15, 17) aufzunehmen, wobei die Bildaufnahmevorrichtung (11) umfasst:
einen ersten Objektivtubus (31), der ein erstes optisches System (65) aufnimmt;
einen zweiten Objektivtubus (31), der ein zweites optisches System (65) aufnimmt, wobei eine optische Achse (57) des ersten optischen Systems (65) parallel zu einer optischen Achse (57) des zweiten optischen Systems (65) verläuft;
einen Halter (33), der den ersten Objektivtubus (31) und den zweiten Objektivtubus (31) abdeckt und fixiert und ein Spitzenende (59), in das Licht von dem Objekt (15, 17) eintritt, und ein Basisende (61) auf einer dem Spitzenende (59) gegenüberliegenden Seite aufweist;
einen Flanschabschnitt (35), der von einer Außenperipherie des Basisendes (61) vorsteht und an dem beweglichen Körper (25) befestigt ist;
einen Bildsensor (63), der ausgestaltet ist, ein Bild des durch das erste optische System (65) und das zweite optische System (65) übertragenen Lichts zu bilden; und
eine Sensorplatine (37), auf der der Bildsensor (63) angebracht ist,
wobei der Bildsensor (63) am Basisende (61) des Halters (33) befestigt ist.

2. Stereo-Bildaufnahmevorrichtung (11) nach Anspruch 1, wobei eine gesamte Länge des ersten Objektivtubus (31) in einer Richtung entlang einer optischen Achse (57) des ersten optischen Systems (65) und eine gesamte Länge des zweiten Objektivtubus (31) entlang einer optischen Achse (57) des zweiten optischen Systems (65) von der Halterung (33) abgedeckt sind.

3. Stereo-Bildaufnahmevorrichtung (11) nach Anspruch 1 oder 2, wobei das Basisende (61) dicker ist als das Spitzenende (59).

4. Stereo-Bildaufnahmevorrichtung (11) nach Anspruch 1,
wobei
das Basisende (61) des Halters (33) mehrere Vorsprünge (105) aufweist und
der Bildsensor (63) an dem Basisende (61) in Kontakt mit den mehreren Vorsprüngen (105) befestigt ist.

5. Stereo-Bildaufnahmevorrichtung (11) nach Anspruch 4, wobei die Sensorplatine (37) über einen Spalt (99) am Basisende (61) befestigt ist.

6. Stereo-Bildaufnahmevorrichtung (11) nach Anspruch 1, wobei der Bildsensor (63) einen Bildsensor (63) umfasst.

7. Stereo-Bildaufnahmevorrichtung (11) nach Anspruch 1, wobei der Bildsensor (63) einen ersten Bildsensor (63), der ein Bild des durch das erste optische System (65) übertragenen Lichts bildet, und einen zweiten Bildsensor (63) umfasst, der ein Bild des durch das zweite optische System (65) übertragenen Lichts bildet.

8. Stereo-Bildaufnahmevorrichtung (11) nach Anspruch 7,
wobei
das Basisende (61) des Halters (33) mehrere erste Vorsprünge (105) und mehrere zweite Vorsprünge (105) umfasst,
der erste Bildsensor (63) an dem Basisende (61) in Kontakt mit den mehreren ersten Vorsprüngen (105) befestigt ist, und
der zweite Bildsensor (63) am Basisende (61) in Kontakt mit den mehreren zweiten Vorsprüngen (105) befestigt ist.

9. Stereo-Bildaufnahmevorrichtung (11) nach Anspruch 8,
wobei
die Sensorplatine (37) eine erste Sensorplatine (37), auf der der erste Bildsensor (63) angebracht ist, und eine zweite Sensorplatine (37) umfasst, auf der der zweite Bildsensor (63) angebracht ist, und
die erste Sensorplatine (37) und die zweite Sensorplatine (37) über einen Spalt (99) gegeneinander angeordnet sind.

10. Stereo-Bildaufnahmevorrichtung (11) nach Anspruch 1,
wobei
das erste optische System (65) mehrere Linsen (L1-L7) umfasst und
das zweite optische System (65) mehrere Linsen (L1-L7) umfasst.

11. Stereo-Bildaufnahmevorrichtung (11) nach Anspruch 1, wobei der Flanschabschnitt (35) mehrere Befestigungslöcher (85) zum Befestigen des Flanschabschnitts (35) an dem beweglichen Körper (25) aufweist.

12. Befestigungsvorrichtung (13), umfassend:
eine Stereo-Bildaufnahmevorrichtung (11) nach einem der Ansprüche 1 bis 11;
einen Anbringkopf (25), der der bewegliche Körper (25) ist und eine Komponente (15) an einer Platine (17) anbringt;
einen Kopfbewegungsmechanismus (27), der den Anbringkopf (25) bewegt; und
eine flexible Platine (39), deren eines Ende mit der Sensorplatine (37) und deren anderes Ende mit dem Anbringkopf (25) verbunden ist,
wobei die Stereo-Bildaufnahmevorrichtung (11) Bilder der vom Anbringkopf (25) gehaltenen Komponente (15) und einer Montageposition der Komponente (15) auf der Platine (17) aufnimmt.

## Revendications

1. Dispositif d'imagerie stéréo (11) fixé à un corps mobile (25) et configuré pour capturer une image d'un objet (15, 17), le dispositif d'imagerie (11) comprenant :
un premier barillet d'objectif (31) qui loge un premier système optique (65) ;
un second barillet d'objectif (31) qui loge un second système optique (65), un axe optique (57) du premier système optique (65) étant parallèle à un axe optique (57) du second système optique (65) ;
un support (33) qui recouvre et fixe le premier barillet d'objectif (31) et le second barillet d'objectif (31) et comprend une extrémité de pointe (59) dans laquelle entre de la lumière provenant de l'objet (15, 17) et une extrémité de base (61) sur un côté opposé à l'extrémité de pointe (59) ;
une portion de bride (35) qui fait saillie d'une périphérie extérieure de l'extrémité de base (61) et est fixée au corps mobile (25) ;
un capteur d'image (63) qui est configuré pour former une image de la lumière transmise à travers le premier système optique (65) et le second système optique (65) ; et
une carte de capteur (37) sur laquelle est monté le capteur d'image (63),
dans lequel le capteur d'image (63) est fixé à l'extrémité de base (61) du support (33).

2. Dispositif d'imagerie stéréo (11) selon la revendication 1, dans lequel une longueur totale du premier barillet d'objectif (31) suivant une direction le long d'un axe optique (57) du premier système optique (65) et une longueur totale du second barillet d'objectif (31) le long d'un axe optique (57) du second système optique (65) sont recouvertes par le support (33).

3. Dispositif d'imagerie stéréo (11) selon la revendication 1 ou 2, dans lequel l'extrémité de base (61) est plus épaisse que l'extrémité de pointe (59).

4. Dispositif d'imagerie stéréo (11) selon la revendication 1,
dans lequel
l'extrémité de base (61) du support (33) présente une pluralité de protubérances (105), et
le capteur d'image (63) est fixé à l'extrémité de base (61) en contact avec la pluralité de protubérances (105).

5. Dispositif d'imagerie stéréo (11) selon la revendication 4, dans lequel la carte de capteur (37) est fixée à l'extrémité de base (61) par un espace (99).

6. Dispositif d'imagerie stéréo (11) selon la revendication 1, dans lequel le capteur d'image (63) comprend un capteur d'image (63).

7. Dispositif d'imagerie stéréo (11) selon la revendication 1, dans lequel le capteur d'image (63) comprend un premier capteur d'image (63) qui forme une image de lumière transmise à travers le premier système optique (65) et un second capteur d'image (63) qui forme une image de lumière transmise à travers le second système optique (65).

8. Dispositif d'imagerie stéréo (11) selon la revendication 7,
dans lequel
l'extrémité de base (61) du support (33) comprend une pluralité de premières protubérances (105) et une pluralité de secondes protubérances (105),
le premier capteur d'image (63) est fixé à l'extrémité de base (61) en contact avec la pluralité de premières protubérances (105), et
le second capteur d'image (63) est fixé à l'extrémité de base (61) en contact avec la pluralité de secondes protubérances (105).

9. Dispositif d'imagerie stéréo (11) selon la revendication 8,
dans lequel
la carte de capteur (37) comprend une première carte de capteur (37) sur laquelle est monté le premier capteur d'image (63) et une seconde carte de capteur (37) sur laquelle est monté le second capteur d'image (63), et
la première carte de capteur (37) et la seconde carte de capteur (37) sont disposées via un espace (99).

10. Dispositif d'imagerie stéréo (11) selon la revendication 1,
dans lequel
le premier système optique (65) comprend une pluralité de lentilles (L1-L7), et
le second système optique (65) comprend une pluralité de lentilles (L1-L7).

11. Dispositif d'imagerie stéréo (11) selon la revendication 1, dans lequel la portion de bride (35) comprend une pluralité de trous de fixation (85) destinés à fixer la portion de bride (35) au corps mobile (25).

12. Dispositif de montage (13) comprenant :
un dispositif d'imagerie stéréo (11) selon l'une quelconque des revendications 1 à 11;
une tête de montage (25) qui constitue le corps mobile (25) et supporte un composant (15) sur une carte (17) ;
un mécanisme de déplacement de tête (27) qui déplace la tête de montage (25); et
une carte flexible (39) dont une extrémité est connectée à la carte de capteur (37) et dont l'autre extrémité est reliée à la tête de montage (25),
dans lequel le dispositif d'imagerie stéréo (11) capture des images du composant (15) retenu par la tête de montage (25) et d'une position de montage du composant (15) sur la carte (17).
